# EUROPEAN PATENT SPECIFICATION

(11) **EP 3 321 134 B1**
(45) Date of publication and mention of the grant of the patent: **07.08.2019**
(21) Application number: 17200326.1
(22) Date of filing: 07.11.2017
(51) Int. Cl.: B60R 13/02, G06F 3/01, G06F 3/044, B60Q 3/208, H03K 17/96, B60Q 3/82, B60Q 3/80, H03K 17/955

(54) **VEHICLE ROOF CONSOLE INTEGRATED WITH CAPACITIVE GESTURE RECOGNITION MODULE**
FAHRZEUGDACHKONSOLE MIT INTEGRIERTEM KAPAZITIVEM GESTENERKENNUNGSMODUL
CONSOLE DE TOIT DE VÉHICULE INTÉGRÉ À UN MODULE DE RECONNAISSANCE DE GESTE CAPACITIF

(30) Priority: 10.11.2016 CN 201610997121
(43) Date of publication of application: 16.05.2018
(73) Proprietor: Robert Bosch GmbH, 70442 Stuttgart (DE)
(72) Inventor: ZHU, Wei, Jiangsu, 215021 (CN); Liu, XinQiang, Jiangsu, 215021 (CN); Shentu, Jiangang, Jiangsu, 215021 (CN); Altmueller, Tobias, 71272 Renningen (DE)

(56) References cited:
- EP-A1- 1 550 579
- WO-A1-2014/138063
- WO-A2-2014/110317
- KR-A- 20160 116 822
- US-A1- 2004 227 625
- US-A1- 2012 049 870
- US-A1- 2016 274 664

## Description

The present invention relates to a vehicle roof console according to the preamble of claim 1 which is known form EP 1 550 579 A1.

### Background Art

If a driver wants to manually manipulate a vehicle appliance when driving a vehicle, the driver has to access a corresponding button or key precisely. Such an action may distract the driver's attention and may further result in danger. For solve this problem, vehicle gesture recognition systems have been proposed.

As an example, according to an image (for example, infrared picture) based recognition technique, the gesture and movement of a hand of the driver in a specified recognition zone is sensed by a camera, then the gesture and movement is recognized to judge the driver's operation intention, so that a corresponding vehicle appliance can be manipulated automatically. There is also a capacitive gesture recognition system that has been developed, which recognizes the gesture and movement of a hand of the driver by sensing the change in the capacitive field caused by the driver's hand gesture and movement in a specified recognition zone and then judges the driver's intention. When a vehicle gesture recognition technique is incorporated in a vehicle, the driver can manipulate the vehicle appliance via a particular movement of a single hand, without wasting too much attention. Thus, the driver can focus on driving the vehicle, and driving safety can be improved.

In current vehicle gesture recognition systems, corresponding components are generally added onto an upper portion of the front windshield or onto the vehicle roof, and thus a certain space of the front windshield or the roof is occupied. What is more, the mounting of some components may be accompanied by modification to the roof trim structure.

### Summary of the Disclosure

An object of the disclosure is to provide a technique for integrating a capacitive gesture recognition module into a vehicle roof console, without the need of additionally occupying a mounting space.

For this end, according to the invention a vehicle roof console integrated with a capacitive gesture recognition module is defined in independent claim 1.

According to the disclosure, the vehicle roof console, which is originally used for roof illumination, sunroof control and the like, is integrated with a capacitive gesture recognition module, so that a compact vehicle roof console with a gesture recognition function is presented. No additional space is occupied for adding the gesture recognition function, the front windshield or the roof is not affected, and the vehicle roof console is easy to be mounted and removed.

### Brief Description of the Drawings

The above and other aspects of the disclosure will be further understood by reading the following detailed description with reference to the drawings in which:
Figure 1 is a schematic bottom view of a vehicle roof console according to a possible embodiment of the disclosure;
Figure 2 is a schematic top view of the vehicle roof console;
Figure 3 is a schematic sectional view of the vehicle roof console;
Figure 4 is a schematic top view of an operation panel of the vehicle roof console with various components assembled thereon;
Figure 5 is a schematic top view of the operation panel of the vehicle roof console with an electric circuit board assembled thereon;
Figure 6 is a schematic top view of the operation panel of the vehicle roof console;
Figure 7 is a schematic top view of a cover plate of the vehicle roof console;
Figure 8 is a view of the cover plate in the direction of arrow "A" in Figure 7;
Figure 9 is a schematic bottom view of the cover plate;
Figure 10 is an schematic top view of the electric circuit board of the vehicle roof console; and
Figure 11 is a view of the electric circuit board in the direction of arrow "B" in Figure 10.

### Detailed Description of Preferred Embodiments

Now some possible embodiments of the vehicle roof console of the disclosure will be described with reference to the drawings. It is noted that the drawings presented here are only illustrative, not forming any restriction to the scope of the disclosure. For the purpose of highlighting some features, various portions of the drawings are not drawn in scale, and some structures are sketched by dotted dash lines, while some other structures are omitted without shown here.

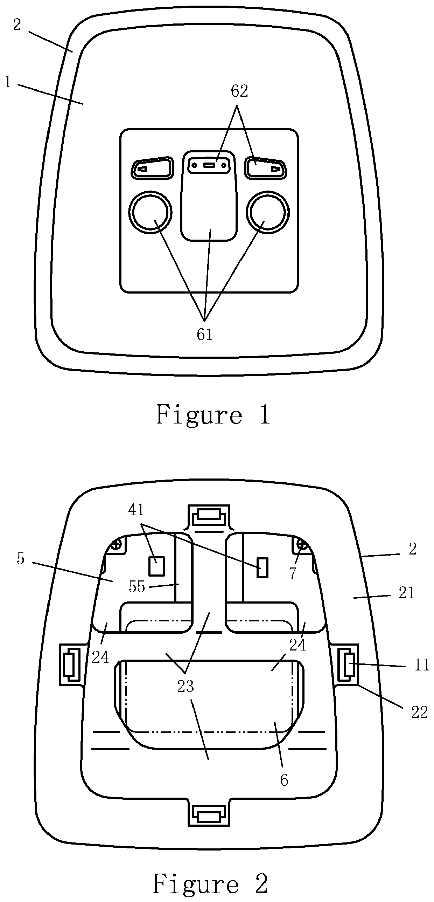

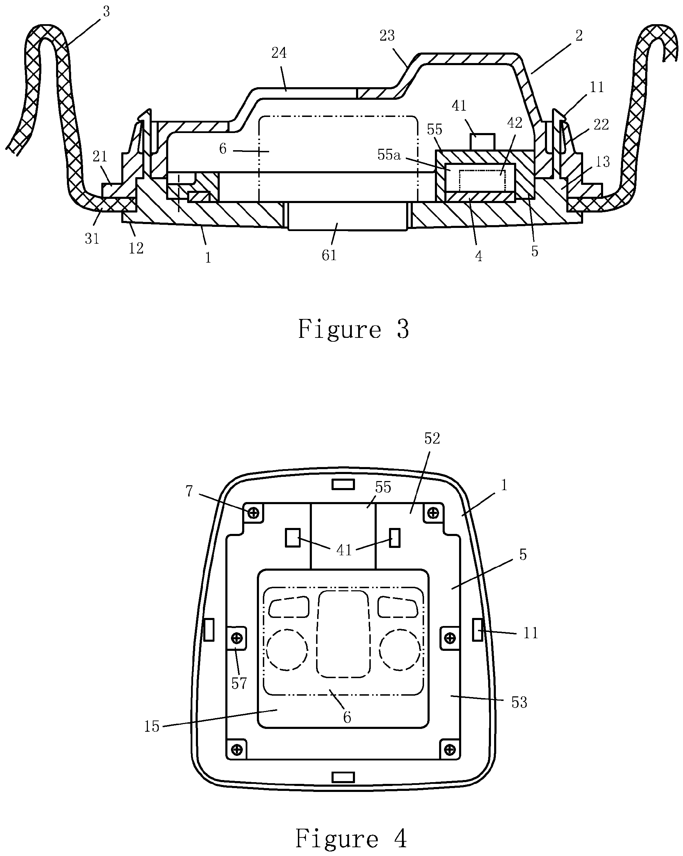

Figures 1-3 schematically show a vehicle roof console according to a possible embodiment of the disclosure, the vehicle roof console comprising an operation panel 1 and a mounting cover 2, wherein the mounting cover 2 is mounted into a mounting socket formed in a roof trim 3 (see Figure 3) from a location above the vehicle roof and is then fixed to the trim 3. After that, the operation panel 1 is assembled to the mounting cover 2 from a location below the vehicle roof In Figures 1 and 2, the trim 3 is omitted for illustrating the positional relation between the operation panel 1 and the mounting cover 2. A casing of the roof console is constituted by the operation panel 1 and the mounting cover 2.

The mounting cover 2 is formed into a single piece of a plastic material. As shown in Figure 3, and with reference to Figure 2, the mounting cover 2 comprises a bottom wall 21, several clamping slot portions 22 formed on the outer peripheral portion of the bottom wall 21, and top wall sections 23 defining a top wall of the mounting cover 2. The bottom wall 21 is in the form of a ring of a substantially flat plat, defining an opening therein. Corresponding to the bottom wall 21, the mounting socket of the trim 3 has a socket bottom plate 31, with an opening formed in the socket bottom plate 31, the opening having a shape substantially consistent with the opening in the bottom wall 21. When the mounting cover 2 is being assembled to the mounting socket of the trim 3, the bottom wall 21 is pushed against the socket bottom plate 31, with their openings aligned with each other. The mounting cover 2 may be fixed to the trim 3, in particular fixed to the socket bottom plate 31, by fasteners, adhesive or a fitting structure.

The top wall sections 23 of the mounting cover 2 are joined together and extend downwards to the bottom wall 21. In the top wall of the mounting cover 2, there are apertures 24 between the top wall sections 23 to establish an access path between the internal space of the mounting cover 2 and the outside via these apertures 24, so that components inside the mounting cover 2 can be manipulated (for example, to conduct wiring or the like for them). The top wall sections 23 may have different heights with respect to the bottom wall 21 and different shapes, the heights and shapes of them being adapted in accordance with various components to be mounted inside the mounting cover 2.

The operation panel 1 has a substantially plate shaped main body, with several flexible hooks 11 formed on the outer peripheral portion of the upper surface of the main body, the flexible hooks 11 being corresponding to the clamping slot portions 22 of the mounting cover 2. When the flexible hooks 11 are inserted through corresponding clamping slot portions 22 and elastically clamped onto the edges of the clamping slot portions 22, the operation panel 1 is removably fixed to the mounting cover 2, and thus an internal space of the casing is defined between the operation panel 1 and the mounting cover 2.

It is appreciated that other fastening structure and/or fasteners that can removably fix the operation panel 1 to the mounting cover 2 in a simple manner, for example, by only an inserting action, can also be used here.

A capacitive gesture recognition module is carried on the upper side of the operation panel 1. The capacitive gesture recognition module is frame shaped and mainly comprises an electric circuit board 4 and a cover plate 5, the cover plate 5 being configured to sealingly fix the electric circuit board 4 to the operation panel 1. The electric circuit board 4 and the cover plate 5 are located in the internal space of the casing. Connectors 41 and an electric circuit portion 42 (sketched by dotted dash lines in Figure 3) are disposed at a longitudinal end of the electric circuit board 4. For this purpose, a corresponding portion of the cover plate 5 is formed with a raised portion 55, with an inner cavity 55a defined inside the raised portion 55. The electric circuit portion 42 is accommodated in the inner cavity 55a, and the connectors 41 extend upwards through the cover plate 5 to be exposed from the cover plate 5. As shown in Figure 2, via a corresponding aperture 24 in the top wall of the mounting cover 2, an operator can manipulate the connectors 41 from upside, for example, to conduct wiring.

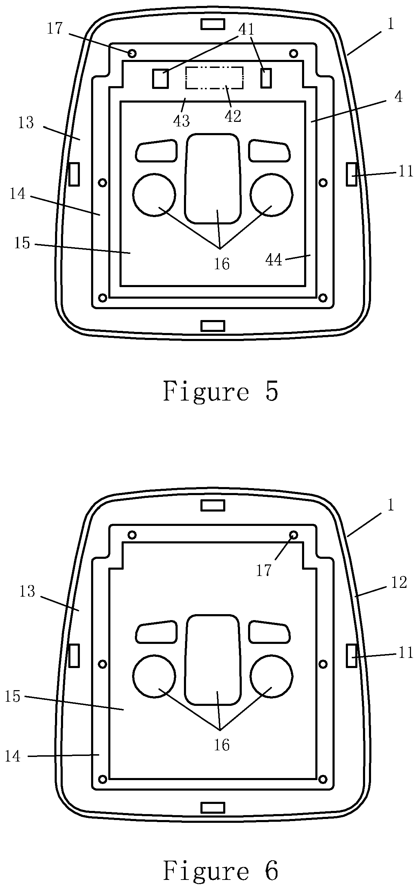

Further, a roof illumination module 6 (sketched by dotted dash lines) is mounted to the operation panel 1, the roof illumination module 6 being mounted substantially to a middle portion of the operation panel 1. The electric circuit board 4 and the cover plate 5 each have a hollow central portion, so that that they can be arranged to surround the roof illumination module 6. The roof illumination module 6 comprises roof lights 61 and light switches 62, all of them passing through corresponding holes 16 (see Figures 5 and 6, etc.) in the operation panel 1 to be exposed to a lower side of the operation panel 1 (i.e., exposed to the vehicle cabin).

The roof illumination module 6 may be mounted to the operation panel 1 quickly in a snap-on manner. Of course, other mounting manners, for example, by using fasteners or other fitting structures, are also feasible.

Other modules, for example, a sunroof control module for controlling the operation of a sunroof of the vehicle, or the like, may also be mounted to the operation panel 1. Said other modules are also surrounded by the electric circuit board 4 and the cover plate 5, and are mounted to the operation panel 1 in a way similar to the roof illumination module 6. Of course, said other modules may alternatively not be surrounded by the electric circuit board 4 and the cover plate 5, but be disposed on the outside of the electric circuit board 4 and the cover plate 5. Like the roof lights 61 and light switches 62, manipulation knobs for other modules (the sunroof control module, etc.) pass through corresponding holes in the operation panel 1 to be exposed to the lower side of the operation panel 1. Since the manner of mounting other modules (the sunroof control module, etc.) with respect to the casing and the operation manner of them are similar to that of the roof illumination module 6, only the roof illumination module 6 will be described in details here. It is appreciated that the description to the roof illumination module 6 is equally applicable to other modules (the sunroof control module, etc.).

The cover plate 5 may be fixed to the operation panel 1 by means of screws 7 as illustrated, or by means of other fasteners or fastening structures. By arranging the electric circuit board 4 and the cover plate 5 around the roof illumination module 6 (and may also around the sunroof control module or other modules), the capacitive gesture recognition module is independent with respect to the roof illumination module 6 (and also the sunroof control module or other modules) without interference with each other. The roof illumination module 6 (and also the sunroof control module or other modules) is not affected during the mounting and removing of the capacitive gesture recognition module. Further, the roof illumination module 6 and other possibly presented modules (the sunroof control module, etc.) are also independent of each other. The capacitive gesture recognition module, the roof illumination module 6 and other possibly presented modules (the sunroof control module, etc.) may be manufactured individually, and then assembled to the casing of the roof console of the disclosure without interference with each other. After that, they can be repaired, removed and replaced independently. Thus, the assembly and maintenance of the roof console of the disclosure is convenient.

Figure 6 shows the operation panel 1 from upper side, the operation panel 1 being a single piece made of plastic and having a substantially trapezoidal profile. The operation panel 1 comprises a ring of an outermost rim portion 12, and a ring of a raised portion 13 protruded upwards near the rim portion 12. In the assembled state shown in Figure 3, the raised portion 13 is inserted though the opening in the socket bottom plate 31 of the trim 3 into the mounting cover 2, the portion of the socket bottom plate 31 at the opening is clamped between the bottom wall 21 of the mounting cover 2 and the rim portion 12 of the operation panel 1, so that the whole casing is fixed to the trim 3.

The operation panel 1 further comprises a ring of a strip of support portion 14 at the inner side of the raised portion 13, the strip of support portion 14 having an inner profile that is substantially consistent with the outer profile of the electric circuit board 4. A mounting area 15 is formed at the inner side of the strip of support portion 14, the mounting area 15 comprising an circuit board mounting area (not marked in the figures) at the outer periphery and a middle portion surrounded by the circuit board mounting area, the electric circuit board 4 being supported by the circuit board mounting area, and the middle portion being configured for forming the holes 16 therein and for supporting the roof illumination module 6 (and other possibly presented modules, such as the sunroof control module). The strip of support portion 14 may be slightly higher than the mounting area 15, and screw holes 17 are formed in the strip of support portion 14, the screws 7 (if they are used) being screwed into the screw holes 17 and tightened herein.

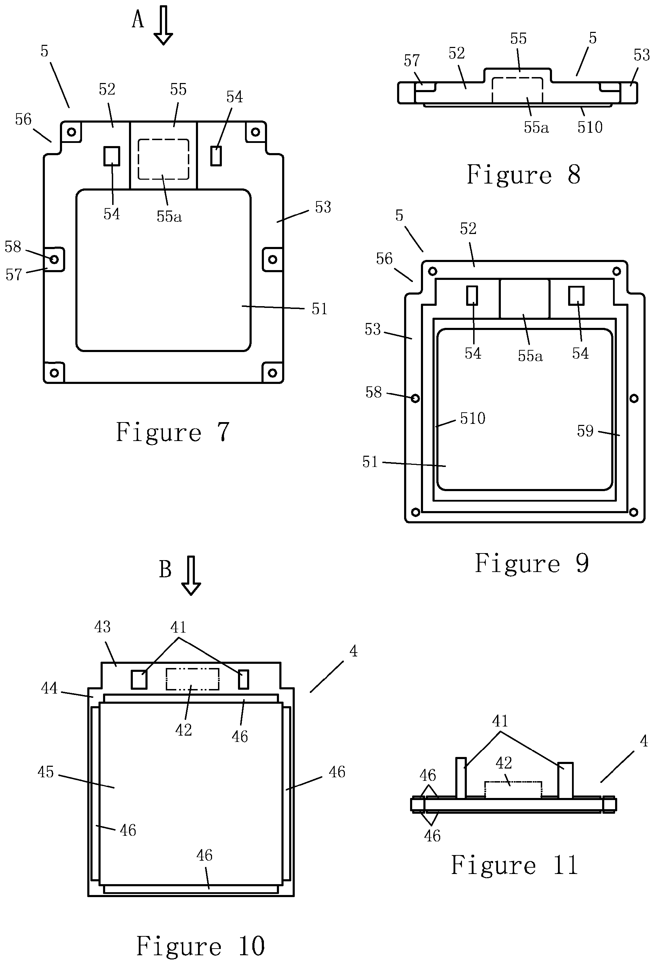

Figures 10 and 11 show the electric circuit board 4 in different directions, the electric circuit board 4 having a shape that permits it to be mounted to the operation panel 1 around the roof illumination module 6 (and/or other possibly presented modules), such as a frame shape in any one of various closed forms (for example, rectangular, trapezoidal, polygonal, etc.) or non-closed forms (for example, U-shape, V-shape, etc.). In the illustrated exemplary embodiments, the electric circuit board 4 has a main body having a shape of a substantially rectangular frame, the frame defining a hollow portion therein. The frame comprises a wider first frame portion 43 and three narrower second frame portions 44. On the first frame portion 43, the connector 41 and the electric circuit portion 42 associated with the connector 41 are mounted. For example, as shown in this figure, two connectors 41 and one electric circuit portion 42 between the two connectors 41 are mounted. Opposite corners of the first frame portion 43 are recessed laterally inwards to accommodate the substantially trapezoidal outer periphery of the operation panel 1. Further, several capacitive field sensors, four capacitive field sensors as shown in the figure, are disposed on the frame. Each capacitive field sensor comprises a pair of strip shaped capacitive electrodes 46 disposed on upper and lower sides of the frame respectively. In each pair of the capacitive electrodes 46, one is an emitter electrode, and the other is a receiver electrode, with a capacitive field being generated between the emitter electrode and the receiver electrode. The capacitive field covers a zone located upper behind the central console of the vehicle. When a hand of the driver presents a certain action or gesture, the capacitive field is changed, and the electric circuit portion 42 senses the change in the capacitive field. The change in the capacitive field is used to judge the gesture of the driver's hand and thus determine the intention of the driver. Judging the gesture of the driver's hand and determining the intention of the driver can be achieved by the electric circuit portion 42, or by a control unit that is connected to the electric circuit portion 42. The control unit can control the corresponding vehicle appliance based on the driver's intention.

In the above embodiments, the second frame portions 44 only need to have a width that is enough for carrying the capacitive electrodes 46, and thus can be formed to be narrow, which facilitates the arrangement on the operation panel 1.

According to an alternative embodiment, the connector 41 and the electric circuit portion 42 can be arranged on a separate electric circuit board which is also mounted to the operation panel 1, and the separate electric circuit board is connected with the electric circuit board 4 via wiring. In this embodiment, the first frame portion 43 may be formed to be as narrow as the second frame portions 44, that is to say, the first frame portion 43 only need to have a width that is enough for carrying the capacitive electrodes 46.

Figures 7-9 show the cover plate 5 in different directions, the cover plate 5 being also a single piece made of plastic and having a shape suitable for surrounding the roof illumination module 6 (and/or other possibly presented modules), such as a frame shape in any one of various closed forms (for example, rectangular, polygonal, etc.) or non-closed forms (for example, U-shape, V-shape, etc.). In the illustrated exemplary embodiments, the cover plate 5 comprises a substantially rectangular frame, the inner side of which defines a hollow portion 51. The frame comprises a wider first frame portion 52 and three narrower second frame portions 53. The first frame portion 52 is formed with connector holes 54 to be inserted through by the connectors 41 of the electric circuit board 4, and is formed with the raised portion 55 that is located between the connector holes 54 and defines the inner cavity 55a. Opposite corners of the first frame portion 52 are recessed laterally inwards to form recessed portions 56 so as to accommodate the substantially trapezoidal outer periphery of the operation panel 1. Undercuts 57 are formed at suitable locations of the cover plate 5, defining a decreased thickness here, and through holes 58 to be inserted through by the screws 7 are formed in portions corresponding to the undercuts 57.

As shown in Figure 9, the bottom side of the cover plate 5 is formed with a recess 59 for accommodating the electric circuit board 4. The inner cavity 55a and the connector holes 54 are all opened into the recess 59. The inner periphery of the recess is defined by an inner peripheral ridge 510. As shown in Figure 8, the inner peripheral ridge 510 protrudes downwards slightly with respect to the bottom surface of the main body of the cover plate 5, to match with the height difference between the strip of support portion 14 and the mounting area 15 of the operation panel 1.

The electric circuit board 4 is arranged on the circuit board mounting area of the mounting area 15 of the operation panel 1 in an orientation in which the connector 41 and the electric circuit portion 42 face upwards, as shown in Figure 5.

After that, as shown in Figure 4, the cover plate 5 is covered onto the electric circuit board 4, and the electric circuit board 4 is sealed between the cover plate 5 and the operation panel 1. The connectors 41 are inserted through the connector holes 54 of the cover plate 5 to be exposed, and the gap between the connector 41 and the cover plate 5 can be sealed by means of a suitable sealing structure, sealing elements or a sealing material. Then, the cover plate 5 is fixed to the operation panel 1, for example, by using the screws 7. Since the electric circuit board 4 and the cover plate 5 both have a hollow middle portion, the middle portion of the mounting area 15 is not occupied and faces upwards after the electric circuit board 4 and the cover plate 5 are mounted to the operation panel 1. Now the roof illumination module 6 and other possibly presented modules (the sunroof control module, etc.) can be mounted on the operation panel 1.

Next, the operation panel 1, which carries the capacitive gesture recognition module, the roof illumination module 6 and other possibly presented modules (the sunroof control module, etc.), is assembled to the mounting cover 2 via the opening in the socket bottom plate 31 of the trim 3, as shown in Figure 3, so that a complete roof console is formed.

It shall be noted that, in the embodiments that are shown in the figures and described above, the electric circuit board 4 and the cover plate 5 are each in the form of a substantially rectangular frame, and thus the capacitive gesture recognition module is generally in the form of a substantially rectangular frame. The expression "substantially rectangular" used here means that neighboring sides of it may not form an absolute right angle therebetween, but there may be a small deviation, for example, less than 10 degrees, from absolute right angle. For example, the first frame portion 52 and a neighboring second frame portions 53 may form an angle therebetween in the range of 90 degrees ±10 degrees, preferably 90 degrees ±5 degrees.

It is appreciated that the capacitive gesture recognition module (as well as the electric circuit board 4 and the cover plate 5 of it) of the disclosure may be formed as a frame of other shapes, for example, a frame having a trapezoidal shape, a polygonal shape and so on. In this condition, the total number, the shapes and the positions of the frame portions of the electric circuit board 4 and the cover plate 5 may be determined according to concrete structure. A key point of the disclosure is that the frame shaped capacitive gesture recognition module can be disposed independently around the roof illumination module and other possibly presented modules, and the frame shaped capacitive gesture recognition module is particularly suitable for arranging strip shaped capacitive electrodes on it.

It shall be noted that the recognition ability (recognizable hand gestures, recognition precision, etc.) of the capacitive gesture recognition module depends to a large extent on the total number, the size and the distribution of the capacitive electrodes. Thus, for increasing the recognition ability of the capacitive gesture recognition module, as many capacitive electrodes as possible, with as large effective area as possible, can be arranged in the roof console, and the capacitive electrodes shall be located as near the outer periphery of the roof console as possible.

Further, in order to arrange as large capacitive electrodes 46 as possible in the space on the frame of the electric circuit board 4, each capacitive electrode 46 shall extend along the corresponding frame portion to a distance as long as possible. For example, the length of each capacitive electrode 46 is 80% or more of the length of the corresponding frame portion.

It is appreciated that the structure of the roof console that is shown in the figures and described above is only exemplary, and those skilled in the art can design various roof consoles integrated with the capacitive gesture recognition module based on the basic concept of the disclosure and according to concrete vehicle structure.

For example, in the illustrated embodiments, the mounting cover is mounted to the roof trim from upper side; it is appreciated that, however, by making modifications to the structure, the mounting cover may be mounted to the roof trim from the lower side. This solution also falls within the scope of the disclosure.

According to the disclosure, the capacitive gesture recognition module and the roof illumination module and other possibly presented modules (the sunroof control module, etc.) are integrated into the roof console. These modules are mounted independent of each other, so various components in the roof console are easy to be mounted and removed, without interference with each other.

Further, the casing of the roof console comprises a mounting cover and an operation panel mounted from upper and lower sides of the roof trim respectively, and the operation panel can be assembled to the mounting cover by a simple insert-in action, so the assembling and dissembling of the whole roof console is convenient.

Further, the capacitive gesture recognition module is integrated in the existing roof console of the vehicle, and the spare mounting space around the roof illumination module and other possibly presented modules (the sunroof control module, etc.) is particularly efficiently used. The capacitive gesture recognition module incorporates the frame shaped electric circuit board and the frame shaped cover plate which are arranged around the roof illumination module and other possibly presented modules (the sunroof control module, etc.), so no additional mounting space is needed for the capacitive gesture recognition module, and the front windshield or roof trim structure does not need to be modified.

Although the disclosure has been described above with reference to some preferred embodiments, the disclosure is not limited to these embodiments. It is thus appreciated that those skilled in the art can make various modifications to the disclosure without departing from the scope of the disclosure as defined in the following claims.

## Claims

1. A vehicle roof console comprising:
a mounting cover (2) fixed to a roof trim (3) of a vehicle;
an operation panel (1) assembled to the mounting cover (2);
a roof illumination module (6) mounted to a middle portion of the operation panel (1); and
a capacitive gesture recognition module having a frame type configuration, mounted on the operation panel (1) around the roof illumination module (6) and being mechanically independently of the roof illumination module (6);
**characterized in that**
the capacitive gesture recognition module comprises: an electric circuit board (4) comprising pairs of strip shaped capacitive electrodes disposed on opposite sides in a thickness direction of the electric circuit board, each pair of capacitive electrodes comprising an emitter electrode and a receiver electrode; and a cover plate (5) configured to sealingly fix the electric circuit board (4) to the operation panel (1).

2. The vehicle roof console of claim 1, further comprising a sunroof control module mounted to a middle portion of the operation panel (1) independently of the roof illumination module (6); and
optionally, the capacitive gesture recognition module is independently mounted to the operation panel (1) around the roof illumination module (6) and the sunroof control module.

3. The vehicle roof console of claim 1, wherein the electric circuit board (4) is provided with or connected with an electric circuit portion (42), the electric circuit portion (42) being configured to at least sense the change in a capacitive field due to the gesture of a hand of the vehicle driver, the capacitive field being generated by the capacitive electrodes, and the cover plate (5) is formed with a raised portion (55) for accommodating the electric circuit portion (42).

4. The vehicle roof console of claim 1, wherein the electric circuit board (4) is further provided with or connected with a connector (41) associated with the electric circuit portion (42), the cover plate (5) is formed with a connector hole (54) to be inserted through by the connector (41), and the connector (41) is inserted through the connector hole (54) to reach a location above the cover plate (5); and
optionally, the cover plate (5) is formed with a recess (59) for receiving the electric circuit board (4) therein.

5. The vehicle roof console of claim 1, wherein the electric circuit board (4) is in the form of a frame composed of frame portions, each frame portion being provided with corresponding capacitive electrodes on opposite sides in its thickness direction;
optionally, the frame portions comprise a first frame portion (43) which is not only provided with corresponding capacitive electrodes but also carries the electric circuit portion (42) and the connector (41); and second frame portions (44) which are provided only with corresponding capacitive electrodes; and
optionally, each of the second frame portions (44) has a width smaller than that of the first frame portion (43).

6. The vehicle roof console of claim 5, wherein the electric circuit board (4) comprises one first frame portion (43) and three second frame portions (44), the three second frame portions (44) and the one first frame portion (43) together form a substantially rectangular or trapezoidal frame.

7. The vehicle roof console of claim 6, wherein each capacitive electrode has a length that is at least 80% of the length of the corresponding frame portion.

8. The vehicle roof console of any one of claims 1 to 7, wherein the mounting cover (2) is fixed from above to the roof trim (3), and the operation panel (1) is assembled from below to the mounting cover (2); and
optionally, the operation panel (1) is removably assembled to the mounting cover (2) by means of a spring type clip structure.

9. The vehicle roof console of claim 8, wherein the mounting cover (2) is formed with an aperture (24) through which at least the capacitive gesture recognition module and the roof illumination module can be manipulated from above.

## Patentansprüche

1. Fahrzeugdachkonsole, Folgendes umfassend:
eine Montageabdeckung (2), die an einer Dachverkleidung (3) eines Fahrzeugs befestigt ist;
ein Bedienfeld (1), das an der Montageabdeckung (2) angebracht ist;
ein Dachbeleuchtungsmodul (6), das an einen mittleren Abschnitt des Bedienfelds (1) angebracht ist; und
ein kapazitives Gestenerkennungsmodul, das eine rahmenartige Konfiguration aufweist, am Bedienfeld (1) um das Dachbeleuchtungsmodul (6) herum angebracht ist und mechanisch unabhängig von dem Dachbeleuchtungsmodul (6) ist;
**dadurch gekennzeichnet, dass**
das kapazitive Gestenerkennungsmodul Folgendes umfasst:
eine elektrische Leiterplatte (4), umfassend Paare von streifenförmigen kapazitiven Elektroden, die an gegenüberliegenden Seiten in Dickenrichtung der elektrischen Leiterplatte angeordnet sind, wobei jedes Paar von kapazitiven Elektroden eine Emitterelektrode und eine Empfängerelektrode umfasst; und eine Abdeckplatte (5), die konfiguriert ist, die elektrische Leiterplatte (4) am Bedienfeld (1) dichtend zu befestigen.

2. Fahrzeugdachkonsole nach Anspruch 1, ferner umfassend ein Schiebedach-Steuermodul, das an einem mittleren Abschnitt des Bedienfelds (1) unabhängig von dem Dachbeleuchtungsmodul(6) montiert ist; und
das kapazitive Gestenerkennungsmodul gegebenenfalls unabhängig an das Bedienfeld (1) um das Dachbeleuchtungsmodul (6) und das Schiebedach-Steuermodul herum montiert ist.

3. Fahrzeugdachkonsole nach Anspruch 1, wobei die elektrische Leiterplatte (4) mit einem elektrischen Schaltungsabschnitt (42) bereitgestellt oder mit einem solchen verbunden ist, wobei der elektrische Schaltungsabschnitt (42) konfiguriert ist, die Änderung in einem kapazitiven Feld aufgrund der Geste einer Hand des Fahrzeugfahrers zumindest zu erfassen, wobei das kapazitive Feld durch die kapazitiven Elektroden generiert wird, und die Abdeckplatte (5) mit einem erhöhten Abschnitt (55) zum Unterbringen des elektrischen Schaltungsabschnitts (42) ausgebildet ist.

4. Fahrzeugdachkonsole nach Anspruch 1, wobei die elektrische Leiterplatte (4) ferner mit einem Verbinder (41) der dem elektrischen Schaltungsabschnitt (42) zugeordnet ist, bereitgestellt ist oder mit einem solchen verbunden ist, wobei die Abdeckplatte (5) mit einem Verbinderloch (54) ausgebildet ist, durch das der Verbinder (41) einzuführen ist, und der Verbinder (41) durch das Verbinderloch (54) eingeführt wird, um eine Stelle oberhalb der Abdeckplatte (5) zu erreichen; und die Abdeckplatte (5) gegebenenfalls mit einer Aussparung (59) zum Aufnehmen der elektrischen Leiterplatte (4) darin ausgebildet ist.

5. Fahrzeugdachkonsole nach Anspruch 1, wobei die elektrische Leiterplatte (4) in der Form eines Rahmens vorliegt, der aus Rahmenabschnitten zusammengesetzt ist, wobei jeder Rahmenabschnitt mit entsprechenden kapazitiven Elektroden auf gegenüberliegenden Seiten in seiner Dickenrichtung bereitgestellt ist;
die Rahmenabschnitte gegebenenfalls Folgendes umfassen:
einen ersten Rahmenabschnitt (43), der nicht nur mit entsprechenden kapazitiven Elektroden bereitgestellt ist, sondern auch den elektrischen Schaltungsabschnitt (42) und den Verbinder (41) trägt; und zweite Rahmenabschnitte (44), die nur mit entsprechenden kapazitiven Elektroden bereitgestellt sind; und
jeder der zweiten Rahmenabschnitte (44) gegebenenfalls eine Breite aufweist, die kleiner als die des ersten Rahmenabschnitts (43) ist.

6. Fahrzeugdachkonsole nach Anspruch 5, wobei die elektrische Leiterplatte (4) einen ersten Rahmenabschnitt (43) und drei zweite Rahmenabschnitte (44) aufweist, wobei die drei zweiten Rahmenabschnitte (44) und der eine erste Rahmenabschnitt (43) zusammen einen im Wesentlichen rechteckigen oder trapezoiden Rahmen ausbilden.

7. Fahrzeugdachkonsole nach Anspruch 6, wobei jede kapazitive Elektrode eine Länge aufweist, die mindestens 80 % der Länge des entsprechenden Rahmenabschnitts beträgt.

8. Fahrzeugdachkonsole nach einem der Ansprüche 1 bis 7, wobei
die Montageabdeckung (2) von oben an der Dachverkleidung (3) befestigt ist und das Bedienfeld (1) von unten an der Montageabdeckung (2) angebracht ist; und
das Bedienfeld (1) gegebenenfalls lösbar an der Montageabdeckung (2) mittels einer Klammerstruktur vom Federtyp angebracht ist.

9. Fahrzeugdachkonsole nach Anspruch 8, wobei die Montageabdeckung (2) mit einer Öffnung (24) ausgebildet ist, durch welche zumindest das kapazitive Gestenerkennungsmodul und das Dachbeleuchtungsmodul von oben bedient werden können.

## Revendications

1. Console de toit de véhicule, comprenant:
un couvercle de montage (2) fixé à un habillage de toit (3) d'un véhicule;
un panneau de commande (1) assemblé au couvercle de montage (2);
un module d'éclairage de toit (6) monté au niveau d'une partie intermédiaire du panneau de commande (1); et
un module de reconnaissance de geste capacitif présentant une configuration de type toit, monté sur le panneau de commande (1) autour du module d'éclairage de toit (6) et indépendamment du module d'éclairage de toit (6);
**caractérisé en ce que** le module de reconnaissance de geste capacitif comprend une carte de circuit électrique (4) comprenant des paires d'électrodes capacitives en forme de bande disposées sur des côtés opposés dans le sens de l'épaisseur de la carte de circuit électrique, chaque paire d'électrodes capacitives comprenant une électrode émettrice et une électrode réceptrice; et une plaque de recouvrement (5) configurée de manière à fixer de façon étanche la carte de circuit électrique (4) au panneau de commande (1).

2. Console de toit de véhicule selon la revendication 1, comprenant en outre un module de commande de toit ouvrant monté sur une partie intermédiaire du panneau de commande (1) indépendamment du module d'éclairage de toit (6); et
optionnellement, le module de reconnaissance de geste capacitif est monté de façon indépendante sur le panneau de commande (1) autour du module d'éclairage de toit (6) et du module de commande de toit ouvrant.

3. Console de toit de véhicule selon la revendication 1, dans laquelle la carte de circuit électrique (4) est pourvue d'une ou est connectée à une partie de circuit électrique (42), la partie de circuit électrique (42) étant configurée de manière à au moins détecter une variation dans un champ capacitif due à un geste d'une main du conducteur du véhicule, le champ capacitif étant généré par les électrodes capacitives, et la plaque de recouvrement (5) comportant une partie surélevée (55) destine à loger la partie de circuit électrique (42).

4. Console de toit de véhicule selon la revendication 1, dans laquelle la carte de circuit électrique (4) est en outre pourvue d'un ou est connectée à un connecteur (41) associé à la partie de circuit électrique (42), la plaque de recouvrement (5) comporte un trou de connecteur (54) prévu pour l'insertion du connecteur (41), et le connecteur (41) est inséré à travers le trou de connecteur (54) afin d'atteindre un endroit qui est située au-dessus de la plaque de recouvrement (5); et
optionnellement, la plaque de recouvrement (5) comporte un évidement (59) destiné à recevoir la carte de circuit électrique (4) dans celui-ci.

5. Console de toit de véhicule selon la revendication 1, dans laquelle la carte de circuit électrique (4) se présente sous la forme d'un cadre composé de parties de cadre, chaque partie de cadre étant pourvue d'électrodes capacitives correspondantes sur des côtés opposés dans son sens de l'épaisseur;
optionnellement, les parties de cadre comprennent une première partie de cadre (43) qui n'est pas seulement pourvue d'électrodes capacitives correspondantes mais qui porte aussi la partie de circuit électrique (42) et le connecteur (41); et des secondes parties de cadre (44) qui sont uniquement pourvues d'électrodes capacitives correspondantes; et
optionnellement, chacune des secondes parties de cadre (44) présente une largeur qui est inférieure à celle de la première partie de cadre (43).

6. Console de toit de véhicule selon la revendication 5, dans laquelle la carte de circuit électrique (4) comprend une première partie de cadre (43) et trois secondes parties de cadre (44), les trois secondes parties de cadre (44) et la première partie de cadre (43) formant ensemble un cadre sensiblement rectangulaire ou trapézoïdal.

7. Console de toit de véhicule selon la revendication 6, dans laquelle chaque électrode capacitive présente une longueur qui correspond à au moins 80 % de la longueur de la partie de cadre correspondante.

8. Console de toit de véhicule selon l'une quelconque des revendications 1 à 7, dans laquelle le couvercle de montage (2) est fixé par le dessus à l'habillage de toit (3), et le panneau de commande (1) est assemblé par le dessous au couvercle de montage (2); et
optionnellement, le panneau de commande (1) est assemblé de façon détachable au couvercle de montage (2) au moyen d'une structure d'attache du type à ressort.

9. Console de toit de véhicule selon la revendication 8, dans laquelle le couvercle de montage (2) comporte une ouverture (24) à travers laquelle au moins le module de reconnaissance de geste capacitif et le module d'éclairage de toit peuvent être manipulés par le dessus.
